# EUROPÄISCHE PATENTANMELDUNG

(11) **EP 1 371 745 A1**
(43) Veröffentlichungstag der Anmeldung: **17.12.2003**
(21) Anmeldenummer: 02012818.7
(22) Anmeldetag: 10.06.2002
(51) Int. Cl.: C23C 14/08, C23C 14/56, C03C 17/36, C23C 14/02

(54) **Verfahren und Mehrkammervorrichtung zur Beschichtung eines Glassubstrats mit einem Schichtsystem SnO/ZnO/Ag/CrNOx**

(71) Anmelder: Scheuten Glasgroep, 5900 AA Venlo (NL)
(72) Erfinder: Rutten GIED, 5973 KG Lottum (NL); Villari Valentino, 41063 Münchengladbach (DE)
(74) Vertreter: Jostarndt, Hans-Dieter, Dr. Dipl.-Phys.

(57) **Zusammenfassung**

Verfahren zur Beschichtung eines Substrats mit einem Schichtsystem, beschichtetes Substrat und Vorrichtung zur Durchführung des Verfahrens.

Die Erfindung betrifft ein Verfahren zur Beschichtung eines Substrates mit einem Schichtsystem, ein nach dem Verfahren beschichtetes Substrat, das mit dem Schichtsystem beschichtet ist, sowie eine Vorrichtung zur Beschichtung des Schichtsystems.

Erfindungegemäß wird unter die Silberschicht, welche auf das Substrat aufgesputtert wurde, eine keramische ZnO-Schicht als Unterblocker aufgesputtert. Das Aufsputtern des keramischen ZnO geschieht durch Beschuss eines keramischen ZnO-Targets, das einen Gehalt von Al2O3 von 0 - 10 % hat, unter Bedingungen, bei denen keine Beeinflussung durch Sauerstoff erfolgt. Der Schichtwiderstand des beschichteten Substrates wird überraschenderweise deutlich gesenkt.

## Beschreibung

Die Erfindung betrifft ein Verfahren zur Beschichtung eines Substrates mit einem Schichtsystem, ein nach dem Verfahren beschichtetes Substrat, das mit dem Schichtsystem beschichtet ist, sowie eine Vorrichtung zur Beschichtung des Schichtsystems.

Beschichtete Substrate finden in weiten Technologiegebieten Anwendung. Die Beschichtungen dienen dazu, die optischen und/oder chemischen oder mechanischen Eigenschaften von Substraten zu verbessern.

Die Erfindung bezieht sich insbesondere auf transparente Substrate, die mit einem wenigstens teilweise lichtdurchlässigen Schichtsystem versehen sind.

Bei den transparenten Substraten kann es sich beispielsweise um Scheiben aus Kunststoff oder aus Glas handeln. Der Begriff Glas ist hier in einer allgemeinen Bedeutung gemeint und umfasst auch glasartige Materialien wie vitrokristalline Stoffe.

Es ist bekannt, durch geeignete Auswahl der Mehrfachschichten eine geringe Emissionsfähigkeit und/oder gewünschte Transmissions- und/oder Reflektionswerte des beschichteten Substrats zu erzielen. Hierdurch können beispielsweise Wärmeverluste in mit derartigen Substraten versehenen Räumen vermindert werden oder ein Zutritt von Sonnenwärme zu den Räumen verringert werden, während die Lichtdurchlässigkeit in beiden Richtungen nur wenig behindert wird.

Zur Erzielung von gewünschten optischen Eigenschaften wird üblicherweise wenigstens eine Schicht aus einem reflektierenden Material, insbesondere aus Silber, eingesetzt. Die Schicht aus reflektierendem Material ist ausreichend dünn, um Durchlässigkeit für die meisten Strahlen im sichtbaren Bereich des Spektrums zuzulassen, während der größte Teil von Infrarotstrahlung reflektiert wird.

Die Schicht aus Silber ist nach dem Stand der Technik von zwei weiteren Schichten umschlossen, die als Unterblocker und Oberblocker bezeichnet werden. Der Unterblocker befindet sich unter der Silberschicht auf der dem Substrat zugewandten Seite und schützt das Silber vor Diffusion von Fremdatomen, die sich in das Silber einlagern. Der Oberblocker befindet sich auf der Silberschicht und zwar auf der dem Substrat abgewandten Seite. Er dient beispielsweise dem UV-Schutz sowie dem Schutz der Silberschicht vor äußeren chemischen und mechanischen Einwirkungen.

Es sind verschiedene Schichten bekannt, um die Schicht aus reflektierendem Material vor chemischer oder mechanischer Einwirkung zu schützen.

Die zusätzlichen Schichten schützen die reflektierende Schicht physikalisch gegen Abrieb und chemisch gegen Korrosion.

Ein gattungsgemäßes Substrat ist aus der Deutschen Offenlegungsschrift DE 39 41 027 A1 bekannt. Bei diesem beschichteten Substrat ist oberhalb der Glasscheibe eine Schicht aus Titandioxid, eine weitere Schicht aus Zinnoxid und eine weitere Schicht aus Titandioxid angeordnet.

Um solares Infrarotlicht abzuschirmen ist es bekannt, reflektierende Metallschichten, beispielsweise aus Silber aufzubringen. Weiterhin werden antireflektierende Schichten aufgebracht, die ebenfalls Infrarotlicht mit hohem Wirkungsgrad reflektieren, aber zusätzlich Licht einer Wellenlänge im sichtbaren Bereich reflektieren. Beispiele hierfür sind SnO₂, TiO₂, Si₃N₄.
Die antireflektierende Silberschicht wird üblicherweise durch Sputtern in einer nicht-reaktiven sauerstofffreien Atmosphäre, wie beispielsweise Argon, aufgetragen. Das Sputtern geschieht, wie beispielsweise in der WO 00/37384 dargestellt in Vorrichtungen, bei denen das zu beschichtende Substrat durch verschiedene Sputterräume läuft, bei denen verschiedene Targets beschossen werden, um das Beschichtungsmaterial herauszulösen, das sich dann auf dem Substrat niederschlägt. Je nachdem, ob der Sputterraum eine sauerstoffhaltige Atmosphäre hat oder nicht, spricht man von einer oxidischen oder von einer metallischen Zone. Oxidische und metallische Zonen sind durch sogenannte Gastrennungen voneinander getrennt. Dies bedeutet, dass ein Wechsel in der Zusammensetzung der Atmosphäre in der Sputterkammer stattfindet. Meist werden Sputtervorrichtungen eingesetzt, bei denen die Substrate mit einem Förderband durch die verschiedenen Zonen geschleust werden, jedoch kann eine Beschichtung mit verschiedenen Schichten auch in nur einer Sputterkammer vorgenommen werden, bei der die Targets und ggf. die Atmosphärenzusammensetzung gewechselt werden.

Die WO 00/37384 offenbart ein Verfahren, bei dem eine Silberschicht mit einem Oberblocker aus einer ZnO-Keramik beschichtet wird, sowie die mit der ZnO-Keramikschicht beschichtete Silberschicht auf einer Glasscheibe. Sowohl die Silberschicht als auch die ZnO-Schicht werden in einer im Wesentlichen inerten Atmosphäre aufgesputtert, wobei die Sauerstoffkonzentration zwischen 0 und 20 % liegt.

Es ist die Aufgabe der Erfindung, ein Substrat mit einem Schichtsystem zu schaffen, welches eine niedrige Emissivität und eine hohe Bestandsfähigkeit gegenüber Licht und Umweltchemikalien besitzt. Weiterhin soll eine Veränderung, insbesondere Oxidation des Silbers verhindert werden.

Ausgehend vom Oberbegriff des Anspruchs 1 wird die Aufgabe dadurch gelöst, dass unter die Silberschicht eine keramische ZnO-Schicht als Unterblocker aufgesputtert wird.

Die Silberschicht des mit dem erfindungsgemäßen Verfahren beschichteten Substrats hat überraschenderweise einen Schichtwiderstand von nur 3,7 Ohm/sqr gegenüber einem Schichtwiderstand von 4,2 Ohm/sqr nach dem Stand der Technik, bei dem eine ZnO-Schicht mittels eines oxidisch gesputterten Zn-Targets aufgetragen wird. Die erfindungsgemäßen "low-E" Schichtsysteme weisen bei gleicher Silberschichtdicke und Farbgebung eine gesteigerte Transmission von 1-2,5% Punkte auf. Der g-Wert steigt ebenfalls um ca. 1,5 %. Die Mikrokristallinität des ZnO wird verbessert.

Vorteilhafte Weiterbildungen der Erfindung sind in den Unteransprüchen angegeben.

Im Folgenden soll die Erfindung erläutert werden.

Die Figur zeigt eine beispielhafte, schematisierte Schichtabfolge, bei der den Bezugszeichen folgende Bedeutung zukommt:
1. = Substrat, vorzugsweise transparentes Substrat, insbesondere Glas.
2. = Unterschicht (fakultativ)
3. Unterschicht (fakultativ)
4. erfindungsgemäße keramische ZnO-Schicht (Unterblocker)
5. Silberschicht
6. Oberblocker (fakultativ)
7. weitere Oberschicht (fakultativ)

Erfindungsgemäß wird ein vorzugsweise optisch transparentes Substrat 1, welches mit einer Silberschicht 5 beaufschlagt werden soll, mit einer keramischen ZnO-Schicht 4 versehen, die als Unterblocker dient. Hierzu wird das Substrat 1, welches fakultativ bereits mit einer oder mehreren Schichten 2,3 beschichtet sein kann, mittels eines keramischen ZnO-Targets gesputtert. Sowohl das ZnO-Target als auch die gesputterte ZnO-Schicht 4 können einen Gewichtsanteil von 0,1 - 10 % an AlₛOₛ haben. Eine besonders bevorzugte und optimale ZnO-Kristallstruktur zur Verbesserung des Schichtwiderstandes der sich darauf befindlichen Silberschicht wird dann gebildet, wenn die Stoechiometrie zwischen O und Zn möglichst nahe bei 1 liegt, besonders bevorzugt gleich 1 ist. Dies wird durch die Verwendung eines reinen keramischen ZnO oder ZnO/Al₂O₃ Targets erreicht. Die Beimischung von Al₂O₃ ist von Vorteil, da die Kathode mit der Dotierung mit Al₂O₃ leitfähig wird. Dies ist für den DC betriebenen Sputterprozess vorteilhaft. Bei einem AC (Mittelfrequenz) betriebenen Prozess können auch undotierte ZnO Targets eingesetzt werden.

Vorzugsweise geschieht das Sputtern mittels lonenbeschuss mit Argonionen nach einem PVD-Verfahren. Die Argonflüsse liegen beispielsweise in einem Bereich von 50-450 st.cm³/min. Ein bevorzugter Bereich liegt in der Größenordnung von 100-350 st.cm³/min, besonders bevorzugt bei 150-250 st.cm³/min.
Es besteht jedoch auch die Möglichkeit, den Beschuss mit Elektronen vorzunehmen.

Die optimale ZnO-Schichtdicke liegt in einem Bereich von 3-10 nm, vorzugsweise 4 nm, da bei dieser Stärke bereits der erfindungsgemäße Effekt, nämlich die Verringerung des Widerstandes der Silberschicht beobachtet wird und nicht mehr teures Targetmaterial eingesetzt werden muss. Die aufgebrachte Schichtdicke kann natürlich auch mehr als 10 nm betragen.

Der Prozessdruck in der Sputterkammer kann beispielsweise zwischen 1,0-9,9 x 10⁻³ mbar, vorzugsweise 2,5-9,0 x 10⁻³ mbar liegen. Besonders bevorzugt ist ein Prozessdruck von 3,5-8,5 x 10⁻³ mbar.

Vorzugsweise geschieht das Sputtern der ZnO-Schicht 4 in der metallischen Zone, denn die erfindungsgemäßen Vorteile treten nur auf, wenn keine Beeinflussung durch Sauerstoff stattfindet. Bis zu einer Sauerstoffkonzentration von 0-20 %, das heißt, bei einem Sauerstoffgasfluss von 20 st.cm³/min wird keine Beeinflussung des erfindungsgemäßen Schichtwiderstandes von 3,7 Ohm/sqr beobachtet. Das bedeutet, dass der Sauerstoffgehalt in der metallischen Zone von 0 bis zu 20 % betragen darf. Unter diesen Bedingungen ändert sich die Mikrokristallinität sowohl des Silbers als auch des keramischen ZnO nicht.

Beispielhaft können im Folgenden Kathodenanordnungen aufgeführt werden, die zu erfindungsgemäßen Beschichtungsprodukten eingesetzt werden können.

### Beispiel 1:

Deckschicht: (in oxidischer Zone)
Sn/ Sn/ Sn/
Gastrennung:
Unterblocker/Silber/Oberblocker: (in metallischer Zone) ZnO/ Ag/ NiCr
Gastrennung:
....weitere Schichten fakultativ....oxidische Zone

### Beispiel 2:

Deckschicht: (Oxidische Zone)
Sn/ Sn/ Sn/ Ti/
Gastrennung:
Unterblocker/Silber/Oberblocker: (in metallischer Zone) ZnO/ Ag/ NiCr
Gastrennung:
.....weitere Schichten fakultativ oxidische Zone.

### Beispiel 3:

Deckschicht: (Oxidische Zone)
Sn/ Sn/ Sn/ Ti/ Ti
Gastrennung:
Unterblocker/Silber/Oberblocker: (in metallischer Zone) ZnO/ Ag/ NiCr
Gastrennung:
.....weitere Schichten fakultativ oxidische Zone.

Vorzugsweise werden auf die Silberschicht 5 noch Oberblocker 6 und weitere Schichten aufgebracht, die als Deckschichten dienen. Hierzu können die dem Fachmann bekannten Sputtermethoden eingesetzt werden. Als dem Fachmann bekannte Blocker können beispielhaft TiOₓ, NiCrOₓ oder ZnO bzw. ZnO:Al₂O₃ genannt werden. Deckschichten sind beispielsweise der Oberblocker 6 und zusätzliche weitere Schichten 7,8, u.s.w., die Interferenzschichten darstellen.
Die Mindestzahl an Deckschichten besteht aus einem Oberblocker und einer der unten genannten Interferenzschichten.
Vorzugsweise wird mindestens eine Deckschicht aufgetragen. Die Deckschicht hat jedoch keinen Einfluss auf die Verbesserung der Mikrokristallinität des Silbers.

Bevorzugte Zusammensetzungen für die Deckschicht sind:

Blocker/mindestens eine Interferenzschicht:
NiCrOₓ (Blocker)/ SnO₂/ TiO₂
NiCrOₓ (Blocker)/ SnO₂/ ZnO/ TiO₂
NiCrOₓ (Blocker)/ ZnO/ SnO₂/ ZnO/ TiO₂
NiCrOₓ (Blocker)/ Bi₂O₃/ TiO₂
NiCrOₓ (Blocker)/ SnO₂/ ZnO:SnO₂:Al₂O₃ /TiO₂

Diese bevorzugten Zusammensetzungen für die Deckschicht sind beispielhaft für eine Deckschicht, die mindestens aus einem Blocker und mindestens aus einer Interferenzschicht besteht. Als Beispiele für Interferenzschichten können SnO₂, ZnO oder Bi₂O₃ genannt werden. In der Praxis werden jedoch vorzugsweise mindestens zwei Interferenzschichten aufgebracht.

Ebenso sind Kombinationen mit Si₃N₄ und SiO₂ möglich. Prinzipiell können alle transparenten Schichten verwendet werden, die einen Brechungsindex zwischen 1,4 und 2,6 haben.
Die Deckschichten oder Oberschichten des Schichtsystems können oxidisch oder nitridisch und bei Verwendung von keramischen Targets metallisch, das heißt ohne zusätzlichen Eintrag von Reaktivgas, aufgesputtert werden. Keramische Targets haben den Vorteil, dass sie bei gleicher Leistung über eine höhere Sputterrate verfügen und sich immer beinahe der theoretisch mögliche Brechungsindex ausbildet, bedingt durch die nahezu stöchiometrische Zusammensetzung der Schicht. Ein besonders großer Vorteil wird erzielt, wenn ein keramischer Blocker eingesetzt wird. Dieser kann genau wie der ZnO:Al₂O₃ Unterblocker in der metallischen Zone eingesetzt werden. Der ideale Anteil an Sauerstoff im Target führt zu einer optimalen Oxidation und dadurch werden beim Low E noch zusätzlich 1 bis 2% Punkte Transmission gewonnen, verglichen mit einem metallischen Blocker.

Die Schichtdickenbereiche für die Deck- und Oberschicht liegen vorzugsweise zwischen 25 und 65 nm beim low-E Schichtsystem und bei 12 und 45 nm bei einem Doppelsilbersystem.

Im Folgenden sind einige low-E Schichtsysteme mit den jeweiligen Schichtdicken in nm beispielhaft angeführt, bei denen die erfindungsgemäße Verringerung des Schichtwiderstandes beobachtet wird:
1. SnO₂ 10-30 nm/ ZnO 3-10 nm/ Ag 10-16 nm/ NiCrOₓ 2-6 nm/ SnO₂ 35-45 nm/ Zn:Sn 3-10 nm
2. SnO₂ 10-30 nm/ TiO₂ 5-20 nm/ ZnO 3-10 nm/ Ag 10-16 nm/ NiCrOₓ 2-6 nm/ SnO₂ 35-45 nm/ Zn:Sn 3-10 nm.
3. SnO₂ 10-30 nm/ ZnO 3-10 nm/ Ag 10-16 nm/ TiOₓ 2-6 nm/ SnO₂ 35-45 nm/ Zn:Sn 3-10 nm
4. SnO₂ 10-30 nm/ TiO₂ 5-20 nm/ ZnO 3-10 nm/ Ag 10-16 nm/ TiOₓ 2-6 nm/ SnO₂ 35-45 nm/ Zn:Sn 3-10 nm

Nach dem gleichen Schema können auch Doppelsilberschichtsysteme oder auch Mehrfachsilberschichtsysteme hergestellt werden, bei denen wenigstens eine Silberschicht mit keramischem ZnO als Unterblocker unterschichtet ist, die die gleichen Vorteile aufweisen und als doppeltes oder mehrfaches low-E System bezeichnet werden können.

### Beispiel:

SnO₂ 30-35 nm/ ZnO 3-10 nm/ Ag 8-18 nm/ NiCrOₓ 2-6 nm/ SnO₂ 55-65 nm/ ZnO:SnO₂:Al₂O₃ 3-10 nm/ Ag 12-25 nm/ NiCrOₓ 2-6 nm/ SnO₂ 20 nm/ ZnO:SnO₂:Al₂O₃ 3-10 nm.

Allgemein kann bei Doppel- oder Mehrfachschichtsystemen gesagt werden, dass jede Interferenzschicht austauschbar ist.

Bei Oberblockern kann TiOₓ, NiCrOₓ oder ZnO bzw. ZnO:Al₂O₃ verwendet werden.

Schichten, insbesondere aus TiO₂, SiO₂ aber auch NiCrOₓ, können auch durch Sputtern von oxidischen Keramiken aufgebracht werden.

Eine geeignete Vorrichtung zur Durchführung des erfindungsgemäßen Verfahrens umfasst die im Folgenden angegebenen Bestandteile.

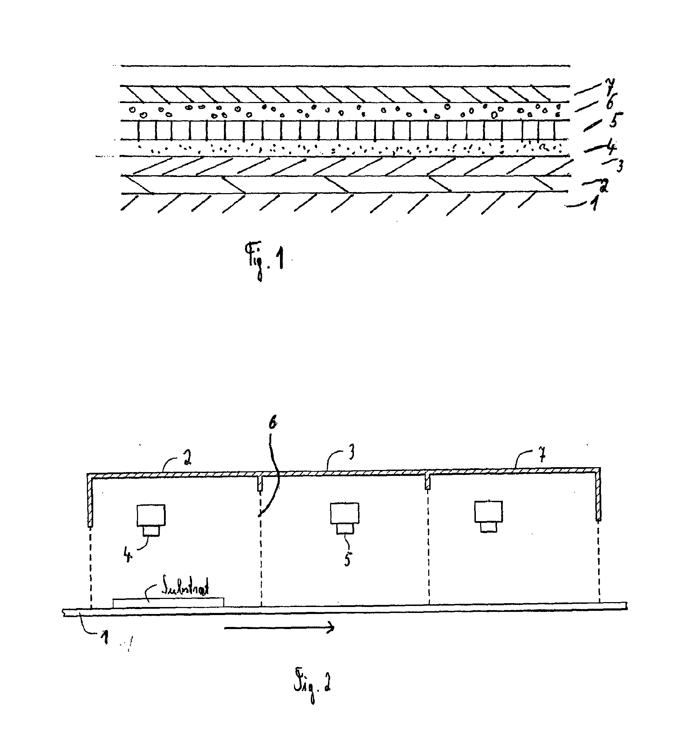

Figur 2 zeigt eine erfindungsgemäße Vorrichtung, bei der ein Transportmittel 1 für ein Substrat in Transportrichtung die Sputterkammern 2 und 3 durchläuft. Sputterkammer 2 beinhaltet ein Target 4 , welches aus ZnO oder im Wesentlichen aus ZnO besteht. Das ZnO-Target kann 0 bis 10 % Al₂O₃ beinhalten, sollte jedoch ein ZnO-Sauerstoffverhältnis von im Wesentlichen 1 zu 1 aufweisen. Sputterkammer 3 beinhaltet ein Silbertarget 5. Die Sputterkammern 2 und 3 sind durch eine Gasschleuse 6 - als Mittel zur Trennung von zwei Sputterkammern von verschiedenen Gaszusammensetzungen - voneinander getrennt. An die Sputterkammer 3 schließt sich eine weitere Sputterkammer 7 an, welche von der Sputterkammer 3 ebenfalls durch eine Gasschleuse getrennt ist.

### Bezugszeichenliste

- 10: Substrat
- 20: Schichtsystem
- 30: Oberfläche
- 40: erste Schicht
- 50: Unterschicht
- 60: metallische Schicht
- 70: Schutzschicht
- 80: Haftvermittlerschicht
- 90: Schutzschicht
- 100: metallische Schicht
- 110: Deckschicht

## Patentansprüche

1. Sputterverfahren zur Beschichtung eines Substrates mit einer Silberschicht und einem sich unter der Silberschicht befindendem Unterblocker, **dadurch gekennzeichnet,**
**dass** zum Aufbringen des Unterblockers ein Target verwendet wird, das im Wesentlichen aus ZnO besteht oder einen Gehalt von 0-10% Al₂O₃ hat, wobei eine Beschichtung aus keramischem ZnO entsteht, die einen Anteil von 0 bis 10 % Al₂O₃ aufweist, dass nach dem Aufbringen eine Gastrennung erfolgt und anschließend eine Beschichtung des Unterblockers mittels eines Silbertargets erfolgt.

2. Sputterverfahren nach Anspruch 1,
**dadurch gekennzeichnet,**
**dass** die Beschichtung mittels ZnO ohne bzw. geringe Beeinflussung durch Sauerstoff stattfindet.

3. Sputterverfahren nach Anspruch 2
**dadurch gekennzeichnet,**
**dass** die Beschichtung mit ZnO in einer metallischen bzw. stark sauerstoffreduzierten Zone stattfindet.

4. Sputterverfahren nach Anspruch 2 oder 3,
**dadurch gekennzeichnet,**
**dass** die Sauerstoffkonzentration zwischen 0 und 20 % liegt.

5. Sputterverfahren nach einem der Ansprüche 1 bis 4,
**dadurch gekennzeichnet,**
**dass** der Prozessdruck in einem Bereich zwischen 1,0 x 10⁻³ und 9,9 x 10⁻³ mbar liegt.

6. Sputterverfahren nach einem der Ansprüche 2 bis 5,
**dadurch gekennzeichnet,**
**dass** mittels Argonionenbeschuss gesputtert wird.

7. Sputterverfahren nach einem der Ansprüche 2 bis 6,
**dadurch gekennzeichnet,**
**dass** das Sputtern bei einem Argonfluss zwischen 50 bis 450 st.cm³/min durchgeführt wird.

8. Sputterverfahren nach einem der Ansprüche 1 bis 7,
**dadurch gekennzeichnet,**
**dass** eine ZnO-Schicht einer Stärke von 3-10 nm aufgebracht wird.

9. Sputterverfahren nach Anspruch 8,
**dadurch gekennzeichnet,**
**dass** eine ZnO-Schicht einer Stärke von 4 nm aufgebracht wird.

10. Sputterverfahren nach einem der Ansprüche 1 bis 9,
**dadurch gekennzeichnet,**
**dass** eine Silberschicht einer Stärke von 10-16 nm aufgebracht wird.

11. Sputterverfahren nach einem der Ansprüche 1 bis 10,
**dadurch gekennzeichnet,**
**dass** die Silberschicht in einer metallischen Zone aufgebracht wird.

12. Sputterverfahren nach einem der Ansprüche 1 bis 11,
**dadurch gekennzeichnet,**
**dass** auf die Silberschicht ein Oberblocker aufgesputtert wird.

13. Sputterverfahren nach Anspruch 12,
**dadurch gekennzeichnet,**
**dass** der Oberblocker NiCrOₓ ist.

14. Sputterverfahren nach Anspruch 13,
**dadurch gekennzeichnet,**
**dass** das NiCrOₓ durch Sputtern von NiCr in der metallischen Zone erfolgt.

15. Sputterverfahren nach einem der Ansprüche 1 bis 14,
**dadurch gekennzeichnet,**
**dass** auf die Silberschicht mindestens eine weiter Schicht aufgesputtert wird.

16. Sputterverfahren nach Anspruch 15,
**dadurch gekennzeichnet,**
**dass** mindestens eine Interferenzschicht aufgesputtert wird.

17. Sputterverfahren nach einem der Ansprüche 1 bis 16,
**dadurch gekennzeichnet,**
**dass** auf das Substrat vor dem Aufsputtern des keramischen ZnO Unterblockers mindestens eine weitere Schicht aufgesputtert wird.

18. Sputterverfahren nach Anspruch 17,
**dadurch gekennzeichnet,**
**dass** eine SnO₂-Schicht aufgesputtert wird.

19. Sputterverfahren nach Anspruch 18,
**dadurch gekennzeichnet,**
**dass** die SnO₂-Schicht in einer oxidischen Zone aufgesputtert wird.

20. Sputterverfahren nach einem der Ansprüche 17 bis 19,
**dadurch gekennzeichnet,**
**dass** nach dem Aufbringen der weiteren Schicht und vor dem Aufsputtern des keramischen Unterblockers eine Gastrennung vorgenommen wird.

21. Sputterverfahren nach einem der Ansprüche 1 bis 20,
**dadurch gekennzeichnet,**
**dass** ein Substrat beschichtet wird, das transparent ist.

22. Sputterverfahren nach Anspruch 21,
**dadurch gekennzeichnet,**
**dass** das Substrat Glas ist.

23. Beschichtetes Substrat,
**dadurch gekennzeichnet,**
**dass** es mit einem Verfahren nach einem der Ansprüche 1 bis 22 hergestellt wurde.

24. Sputtervorrichtung umfassen ein Transportmittel und eine Sputterkammer mit einem Target,
**dadurch gekennzeichnet,**
**dass** sie in Transportrichtung des Transportmittels 1 eine Sputterkammer 2 besitzt, die ein ZnO-Target eines Al₂O₃-Anteils von 0-10 % aufweist, die durch eine Gastrennung 4 von einer weiteren Sputterkammer 3 getrennt ist, die sich an die Sputterkammer 2 anschließt und die ein Silbertarget beinhaltet.

25. Vorrichtung nach Anspruch 24,
**dadurch gekennzeichnet,**
**dass** die Sputterkammer 2 eine Argonionenquelle besitzt.
